# EUROPEAN PATENT SPECIFICATION

(11) **EP 2 682 994 B1**
(45) Date of publication and mention of the grant of the patent: **27.04.2016**
(21) Application number: 12755014.3
(22) Date of filing: 02.03.2012
(51) Int. Cl.: H01L 35/22, H01L 35/32, H01L 35/34, H01L 35/24

(54) **THERMOELECTRIC CONVERSION MATERIAL, AND FLEXIBLE THERMOELECTRIC CONVERSION DEVICE USING SAME**
MATERIAL FÜR THERMOELEKTRISCHE UMWANDLUNG SOWIE VORRICHTUNG FÜR THERMOELEKTRISCHE UMWANDLUNG DAMIT
MATÉRIAU DE CONVERSION THERMOÉLECTRIQUE ET DISPOSITIF DE CONVERSION THERMOÉLECTRIQUE FLEXIBLE METTANT EN OEUVRE LEDIT MATÉRIAU

(30) Priority: 04.03.2011 JP 2011047954; 18.01.2012 JP 2012008040
(43) Date of publication of application: 08.01.2014
(73) Proprietor: National Institute of Advanced Industrial Science and Technology, Tokyo 100-8921 (JP)
(72) Inventor: SUEMORI Kouji, Tsukuba-shi Ibaraki 305-8565 (JP); KAMATA Toshihide, Tsukuba-shi Ibaraki 305-8565 (JP)
(74) Representative: Hoffmann Eitle
(86) International application number: PCT/JP2012/055333
(87) International publication number: WO 2012/121133

(56) References cited:
- JP-A- 3 066 182
- JP-A- 2006 261 384
- JP-A- 2006 507 692
- US-A1- 2010 319 745
- DASAROYONG KIM ET AL: "Improved Thermoelectric Behavior of Nanotube-Filled Polymer Composites with Poly(3,4-ethylenedioxythiophene) Poly(styrenesulfonate)", ACS NANO, vol. 4, no. 1, 26 January 2010 (2010-01-26), pages 513-523, XP055028192, ISSN: 1936-0851, DOI: 10.1021/nn9013577
- QIN YAO ET AL: "Enhanced Thermoelectric Performance of Single-Walled Carbon Nanotubes/Polyaniline Hybrid Nanocomposites", ACS NANO, vol. 4, no. 4, 27 April 2010 (2010-04-27), pages 2445-2451, XP055130628, ISSN: 1936-0851, DOI: 10.1021/nn1002562
- COREY A. HEWITT ET AL: "Multilayered Carbon Nanotube/Polymer Composite Based Thermoelectric Fabrics", NANO LETTERS, vol. 12, no. 3, 14 March 2012 (2012-03-14) , pages 1307-1310, XP055128908, ISSN: 1530-6984, DOI: 10.1021/nl203806q
- HEWITT C ET AL: "Varying the concentration of single walled carbon nanotubes in thin film polymer composites, and its effect on thermoelectric power", APPLIED PHYSICS LETTERS, AMERICAN INSTITUTE OF PHYSICS, US, vol. 98, no. 18, 5 May 2011 (2011-05-05), pages 183110-183110, XP012140571, ISSN: 0003-6951, DOI: 10.1063/1.3580761
- F. RIVADULLA ET AL.: 'Layer-by-Layer Polymer Coating of Carbon Nanotubes: Tuning of Electrical Conductivity in Random Networks' JOURNAL OF THE AMERICAN CHEMICAL SOCIETY vol. 132, no. 11, 25 February 2010, pages 3751 - 3755, XP055129097
- CHOONGHO YU ET AL.: 'Thermoelectric Behavior of Segregated-Network Polymer Nano-composites' NANO LETTERS vol. 8, no. 12, 30 October 2008, pages 4428 - 4432, XP055129101

## Description

### TECHNICAL FIELD

The present invention relates to a thermoelectric conversion material, a thermoelectric conversion element using the material, and a device that uses waste heat of, for example, an electronic apparatus and a vehicle by using the element.

### BACKGROUND ART

The thermoelectric conversion material is a material that is capable of converting thermal energy and electric energy to each other by using a Peltier effect or a Seebeck effect, and when a temperature difference is applied between both ends of the element that uses the thermoelectric conversion material, electricity is generated due to the Seebeck effect. In addition, conversely, when a current is allowed to flow to the element that uses the thermoelectric conversion material, one end absorbs heat and the other end generates heat due to the Peltier effect, and thus the temperature difference occurs between both ends of the element.

The thermoelectric conversion has an advantage in that, for example, waste heat may be effectively used without discharging waste matters during energy conversion. Accordingly, energy may be used with high efficiency, and thus the thermoelectric conversion has attracted an attention.

An apparatus such as an electric apparatus and a vehicle emits a large quantity of waste heat. The conversion of this waste heat into electric power is equivalent to the improvement in electric power usage efficiency of various kinds of apparatuses. The improvement can be realized by installing the thermoelectric conversion element to portions of an electronic apparatus or a vehicle at which waste heat is generated. Specifically, when using a flexible thermoelectric conversion element, this element may be mounted to a waste heat generation portion on an apparatus surface having a faceted surface or a concavity and convexity.

Most of current thermoelectric conversion elements, however, use a solid inorganic semiconductor, and thus the elements are hard and are poor in moldability. The elements are therefore hard to be installed against a shape having a curved surface or concavity and convexity.

In response, studies have been made to expand the use of the thermoelectric conversion element by applying flexibility to the thermoelectric conversion element so as to allow the thermoelectric conversion element to be installed to an object having a curved shape to which thermoelectric conversion elements of the related art could not.

For example, research has been made on thermoelectric conversion materials using an organic material such as pentacene having flexibility (Non-Patent Document 1), and a complex of tetrathiafulvalene and tetracyanoquinodimethane (Non-Patent Document 2).

In addition, suggestions are made of thermoelectric conversion materials composed of a conductive polymer such as polyphenylene vinylene and poly(3-alkylthiophene) subjected to doping treatment (Patent Documents 1 and 2). In a method disclosed in the Patent Documents, a polymer solution is applied on a glass plate to form a film, and the obtained coated film is doped with iodine in vapor phase.

Furthermore, suggestions are also made of hybrid thermoelectric materials including a thermoelectric conversion material such as calcium cobalt oxide, and a carbon nanotube coated with a polymer, a carbon nanofiber coated with a polymer or a conductive polymer (Patent Document 3).

F. Rivadulla et al. in Journal of the American Chemical Society, vol. 132, no. 11, 25 February 2010 pages 3751 to 3755 disclose a thermoelectric conversion material comprising an organic material (polyallylamine hydrochloride (PAH)/polystyrene sulphonate (PSS)) in which fine particles of carbon nanotube (CNT) are dispersed and that has flexibility, and a void. Furthermore, a thermoelectric conversion element comprising a layer of said thermoelectric conversion material over a film substrate is described. Likewise, a method of manufacturing said thermoelectric conversion element is described.

Choongho Yu et al. in Nanoletters, vol. 8, no. 12, 30 October 2008, pages 4428 to 4432 describe a thermoelectric conversion material comprising a polymeric organic material (PVAc) in which fine particles of carbon nanotubes are dispersed and that has flexibility, and a void.

US 2010/319745 A1 discloses a thermoelectric composite material which includes a plurality of carbon nanotubes, wherein said carbon nanotubes are coated with an electrically conductive polymer layer. As exemplary electrically conductive polymer, polyaniline is mentioned.

### RELATED DOCUMENT

### PATENT DOCUMENT

[Patent Document 1] Japanese Unexamined Patent Publication No. 2003-332638
[Patent Document 2] Japanese Unexamined Patent Publication No. 2003-332639
[Patent Document 3] Japanese Unexamined Patent Publication No. 2004-87714
[Patent Document 4] Japanese Unexamined Patent Publication No. 2009-74072

### NON-PATENT DOCUMENT

[Non-Patent Document 1] Kentaro Harada, Mao Sumino, Chihaya Adachi, Saburo Tanaka, and Koji Miyazaki, Appl. Phys. Lett., 96 (2010) 253304.
[Non-Patent Document 2] E. Tamayo, K. Hayashia, T. Shinano, Y. Miyazaki, T. Kajitani, Applied Surface Science 256 (2010) 4554-4558.

### DISCLOSURE OF THE INVENTION

### PROBLEMS TO BE SOLVED BY THE INVENTION

The materials disclosed in Non-Patent Documents 1 and 2, however, do not have a balance between high electrical conductivity and high thermoelectromotive force generation capacity, and exhibit only a low performance.

In addition, the thermoelectric conversion materials disclosed in Patent Documents 1 and 2 are constituted by materials that are unstable when being left as is in the air.

Furthermore, the method disclosed in Patent Document 3 uses an inorganic metal oxide, and uses a rare element that does not have flexibility.

Thus, the lack of a thermoelectric conversion material with a balance between flexibility and high thermoelectric conversion capacity has occurred.

The present invention has been made in consideration of this situation, and an object thereof is to provide a thermoelectric conversion material that can have a balance between flexibility and high thermoelectric conversion capacity, a thermoelectric conversion element using the material, and a device that uses waste heat of, for example, an electronic apparatus and a vehicle by using the element.

### SOLUTION FOR SOLVING PROBLEMS

In order to accomplish the object, the present inventors have studied using a carbon nanotube as a conductive material.

Patent Document 4 describes a resin molded body that is molded after kneading a carbon nanotube and a thermoplastic resin. In contrast, these documents have not studied the thermoelectric conversion material at all.

The present inventors have extensively studied a thermoelectric conversion material using a carbon nanotube. As a result, they have gained knowledge that the above-described object may be accomplished by dispersing a fine particle of a carbon nanotube in an organic polymeric material having flexibility.

The present invention has been accomplished on the basis of the knowledge, and according to the present invention, the following aspects are provided.
[1] A thermoelectric conversion material comprising:
   (i) an organic polymeric material that
      - is soluble in an organic solvent,
      - has electrical insulating or semiconductive properties, and
      - has flexibility,
      in which a fine particle of a carbon nanotube is dispersed, the mass ratio of the carbon nanotube to the organic material being 50-90 % by mass; and
   (ii) a void.
[2] A thermoelectric conversion element, comprising:
   a layer over a film base substrate, the layer being of the thermoelectric conversion material according to [1].
[3] A method of manufacturing the thermoelectric conversion element according to [2], the method comprising:
   applying an application solution on a film substrate or a film substrate having an electrode formed thereon, the application solution being a dispersed solution in which a fine particle of a carbon nanotube and an organic material are dispersed in a solvent such that a mass ratio of the carbon nanotube to the organic material becomes 50 % by mass to 90 % by mass, and drying the application solution to form a thermoelectric conversion layer.
[4] A waste heat utilization device,
   wherein the thermoelectric conversion element according to [2] is installed to be attached to a heat release portion of a facility such as an apparatus and a pipe.
[10] A waste heat utilization device,
   wherein an electronic apparatus having flexibility is set as a substrate, and
   a layer of the thermoelectric conversion material according to [1] is formed over the substrate.

Preferred embodiments become apparent from the following description and the dependent patent claims.

### EFFECT OF THE INVENTION

A thermoelectric conversion element of the related art is made using a solid inorganic semiconductor, and is poor in moldability. Accordingly, it is difficult to install the thermoelectric conversion element to a structure body which has a curved surface and of which a shape varies with the passage of time. A CNT-dispersed organic material of the present invention contains a polymeric material, and thus has high moldability and structural flexibility. In addition, the CNT-dispersed organic material can be easily applied on a plastic substrate having flexibility such that the substrate could be coated. Accordingly, the thermoelectric conversion element of the present invention may be installed at any position. In one example of the use, the thermoelectric conversion element of the present invention is attached to a portion at which waste heat is generated, in a vehicle or various kinds of household electric appliances. This enables improvement in an energy use efficiency (saving of energy) of the vehicle or the various kinds of household electric appliances.

### BRIEF DESCRIPTION OF THE DRAWINGS

FIG. 1 shows a diagram schematically illustrating an example of a thermoelectric conversion element of the present invention, and an aspect in which the thermoelectric conversion element is disposed at a heat release portion of various kinds of apparatuses.
FIG. 2 is a diagram schematically illustrating a structure of an element that is prepared in Example, and a method of applying a temperature difference.
FIG. 3 is a diagram illustrating a Seebeck coefficient in a case of using various kinds of organic materials.
FIG. 4 is a diagram illustrating CNT concentration dependency of the Seebeck coefficient.
FIG. 5 is a diagram illustrating CNT concentration dependency of electrical resistivity.
FIG. 6 is a diagram illustrating CNT concentration dependency of an output factor.
FIG. 7 is a diagram illustrating a surface electron microscope image of CNT-dispersed polystyrene.
FIG. 8 is a diagram illustrating a pattern of a lower electrode.
FIG. 9 is a diagram illustrating a pattern of a CNT-dispersed organic material.
FIG. 10 is a diagram illustrating an edge shape.
FIG. 11 is a diagram illustrating a thermoelectric conversion element that is prepared.

### DESCRIPTION OF EMBODIMENTS

Hereinafter, the present invention will be described.

The thermoelectric conversion material of the present invention is constituted by an organic material containing a polymer in which a fine particle of a carbon nanotube are dispersed and which has flexibility. A mass ratio of the carbon nanotube to the organic material is 50 % by mass to 90 % by mass, and preferably 75 % by mass.

The carbon nanotube (hereinafter, may be referred to as simply "CNT") that is used in the present invention may be either a two-layer carbon nanotube or a multi-layer carbon nanotube. Examples of a method of manufacturing the carbon nanotube include, but are not limited to, known methods of the related art such as a vapor growth method using a catalyst, an arc discharge method, a laser evaporation method, and a HiPco (High-pressure carbon monoxide process) method. When the prepared carbon nanotube is subjected to a heat treatment at 400 °C to 600 °C, or an acid treatment using, for example, sulfuric acid, hydrochloric acid, nitric acid and a hydrogen peroxide solution, impurities such as amorphous carbon are removed, whereby a high-purity carbon nanotube is obtained.

A diameter of the obtained carbon nanotube is commonly approximately 1 nm to 10 nm, and a length thereof is commonly approximately 0.1 µm to 10 µm.

In the present invention, the carbon nanotube obtained in the known method, is pulverized to obtain a fine particle of a carbon nanotube that has a desired size.

As the organic material of the present invention in which the carbon nanotube is dispersed and which has flexibility, a polymeric material which is soluble in an organic solvent and which has electrical insulating properties is used, and preferably, a material having a glass transition temperature that is equal to or higher than room temperature is used.

In the present invention, a proportion at which the carbon nanotube occupies the organic material is 50 % by mass to 90 % by mass, and more preferably 75 % by mass.

When the proportion at which the carbon nanotube occupies the organic material is less than 50 % by mass, the electrical conductivity decreases, and thus the material has a low thermoelectric conversion performance. In addition, when the proportion exceeds 90 % by mass, structural flexibility largely decreases, and thus it may easily collapse when being bent.

In addition, in the present invention, the thermal conductivity may be decreased by foaming the organic material.

Examples of the foaming method include not only a common method of mixing a foaming agent in the organic material but also a method by chemical foaming which uses a decomposition reaction such as photolysis, hydrolysis, thermal decomposition, decomposition by an acid or alkali and decomposition by irradiation of ultraviolet, and a method by a physical foaming agent in which a gas is mixed in a melted resin as a foaming agent.

The thermoelectric conversion element of the present invention is constituted by forming a thermoelectric conversion layer of the above-described thermoelectric conversion material on a film substrate, and by providing electrodes to both ends of the thermoelectric conversion layer.

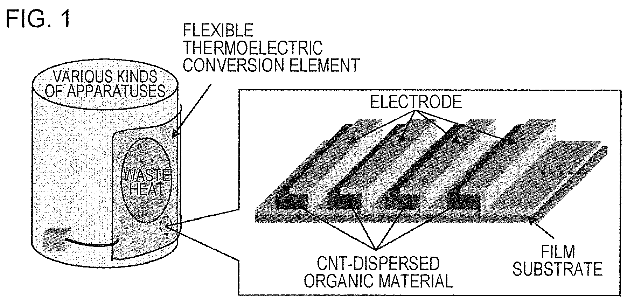

FIG. 1 schematically shows an example of the thermoelectric conversion element of the present invention, and an aspect in which the thermoelectric conversion element is disposed at a heat release portion of various kinds of apparatuses.

As shown in the drawing, in the thermoelectric conversion element of the present invention, the thermoelectric conversion layer of the thermoelectric conversion material is formed on the film substrate, and electrodes are appropriately provided to the thermoelectric conversion layer so as to take out the generated electric power.

As the film substrate, any material may be used, provided that the material is a flexible material capable of enduring a temperature at which the thermoelectric conversion element is exposed. Specifically, a plastic film having a bendable thickness, or a metal film in which an insulating film is formed on a surface thereof and which has a bendable thickness is preferable.

In the present invention, the film substrate may be supported by metal foil within a range not deteriorating flexibility of the film substrate.

A conductive film layer serving as an electrode is formed on the substrate using a material such as ITO, gold, and aluminum as necessary by a deposition method and a printing method, for example.

A method of forming the thermoelectric conversion layer on the film substrate or the film substrate on which the electrode is formed is not particularly limited, but an application method using an application solution in which the thermoelectric conversion material is dispersed in a solvent is preferably used.

As the solvent used in the application solution, an arbitrary solvent may be used, provided that the solvent is capable of dissolving the organic material in which the carbon nanotube is dispersed, and the used amount thereof may be appropriately selected according to a relation with the organic solvent to be used.

The application solution used to form the thermoelectric conversion layer is prepared by stirring a mixed material of a carbon nanotube, the organic material, a material causing a carrier concentration variation to occur in the carbon nanotube as necessary, and a solvent using ultrasonic waves, a ball mill, a bead mill, a stirrer, or the like.

The thermoelectric conversion element of the present invention can be obtained by applying the application solution prepared as described above on the film substrate or the film substrate on which the electrode is formed, drying the application solution to form the thermoelectric conversion layer, and forming the conductive film layer serving as an electrode using a material such as ITO, gold, and aluminum by a method such as a printing method as necessary.

In a case of installing the thermoelectric conversion element of the present invention to an apparatus such as an electronic apparatus and a vehicle, the above-described thermoelectric conversion element may be installed by attaching it to a heat release portion of the apparatus. Alternatively, an electronic device having flexibility is set as a substrate, and the above-described thermal conversion layer and electrodes may be formed on the substrate.

### EXAMPLE

Hereinafter, the present invention may be described on the basis of examples, but the present invention is not limited to the examples.

### (Evaluation Method)

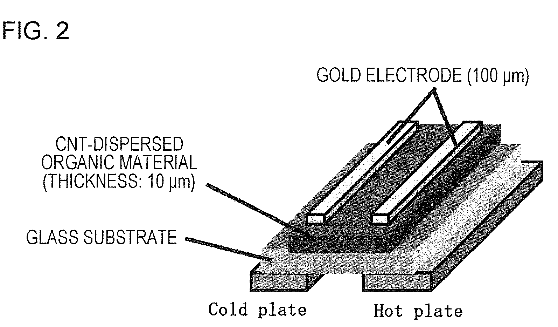

FIG. 2 shows a schematic diagram illustrating a structure of an element manufactured to evaluate thermoelectric conversion characteristics of a material obtained by dispersing a carbon nanotube (CNT) in an organic material having flexibility.

In the element shown in FIG. 2, when a temperature difference is applied by maintaining one of two sheets of gold electrodes at a high temperature and maintaining the other at a low temperature, a voltage is generated between the electrodes. The generated voltage is proportional to the temperature difference between the electrodes. The Seebeck coefficient is estimated based on the proportionality coefficient thereof.

### (Material)

As the carbon nanotube (CNT), a mixture of a single wall type and a multi-wall type (manufactured by carbon nanotechnology inc., product name: Carbon Nanotube, lot No.: XCE602A) was used. In addition, as the organic material, polystyrene (manufactured by sigma-aldrich corporation, product name: polystyrene, product number: 182427-25G, molecular weight: approximately 280,000), polyvinyl carbazole (manufactured by KANTO CHEMICAL CO., INC., product name: polyvinylcarbazol, product number: product number: 32777-31), polyvinyl alcohol (manufactured by sigma-aldrich corporation, product name: Mowiol, product number: 182427-25G, molecular weight: approximately 127,000), and copolymer of polyvinylidene fluoride and trifluoroethylene (manufactured by KUREHA CORPORATION, product name: KF piezo resin (PVDF/TrFE), molecular weight: approximately 350.000) were used.

### (Example 1)

A film (CNT-dispersed film) in which the CNT was dispersed in the organic material was prepared by the following method.

First, as an organic solvent capable of dissolving the above-described organic material, toluene was used to the polystyrene and polyvinyl carbazole, methyl ethyl ketone was used to the copolymer of polyvinyl fluoride and trifluoroethylene, and water was used to the polyvinyl alcohol. In each organic solvent, the CNT and the organic material were adjusted in a container such that the proportion at which the CNT occupied the organic material becomes 17 % by mass to 75 % by mass, and it was stirred using a mill.

At this point of time, a solution in which the CNT was dispersed in the solution of the organic material was obtained.

The solution of the CNT-dispersed organic material was applied onto a glass substrate by a drop cast method to form a film, and drying was performed in the air by retaining the film at approximately 70°C in the case of toluene as the solvent, at approximately 150°C in the case of methyl ethyl ketone, and at approximately 70°C in the case of water. Gold was deposited on the film that was dried in a thickness of 100 nm, whereby an element having a gold electrode was prepared. A film thickness of the CNT-dispersed film was approximately 10 µm as a thickness of a dried film.

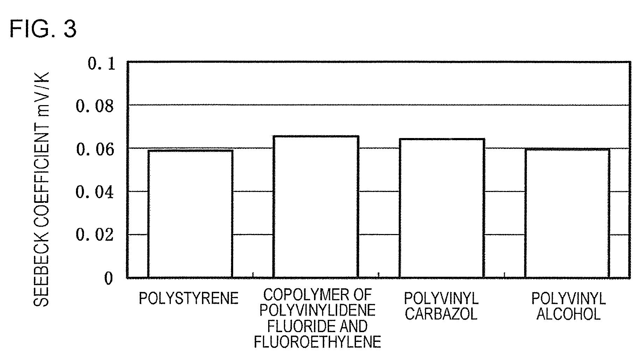

The Seebeck coefficient of materials obtained by dispersing the CNT in the four kinds of organic materials in a mass ratio of 1:1 is shown in FIG. 3. The Seebeck coefficient was estimated by measuring a voltage that was generated by applying a temperature difference between electrodes of the element in the air.

Even in a case where the kinds of the CNT-dispersed organic materials were different from each other, the Seebeck coefficient exhibited a value of approximately 0.06 mV/K. This represents that a thermoelectromotive force was generated by CNT alone, and the organic materials did not contribute to the generation of the thermoelectromotive force.

### (Example 2)

Next, the organic material was limited to polystyrene. When the proportion at which the CNT occupied the polystyrene was changed within a range of 17 % by mass to 75 % by mass, Seebeck coefficient and electrical resistivity were measured. In addition, the electrical resistivity was estimated from an amount of the current that flowed when a voltage was applied to the element in the air.

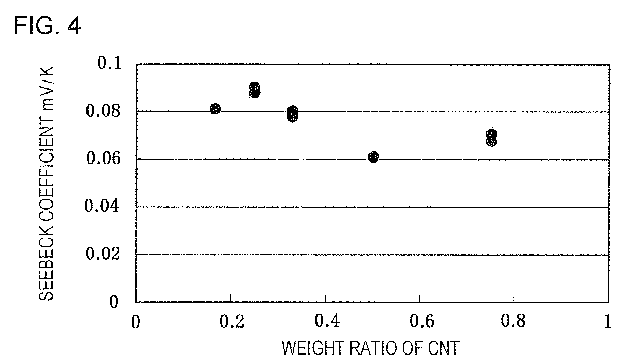

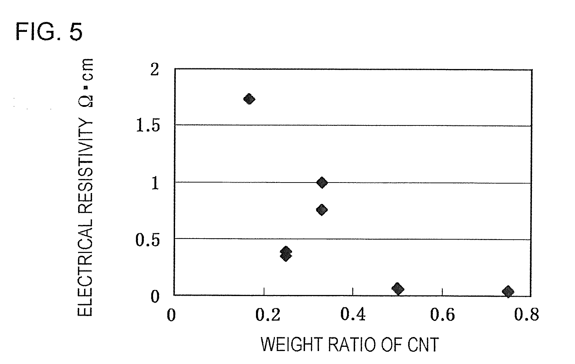

Results are shown in FIGs. 4 and 5.

The Seebeck coefficient slightly varied along with the proportion of the CNT, but great variation was not shown. On the other hand, the electrical conductivity increased along with an increase in the proportion of the CNT.

These results represent that the CNT carries a function of the electrical conduction of the CNT-dispersed organic material.

From the above-described results, it may be concluded that the CNT carries a function of improving electrical conductivity and a function of generating thermoelectromotive force, and the organic material carries a function of applying structural flexibility.

The thermoelectric conversion element generates electricity when a temperature difference is applied thereto, and a power generation capacity per unit temperature difference is referred to as an output factor.

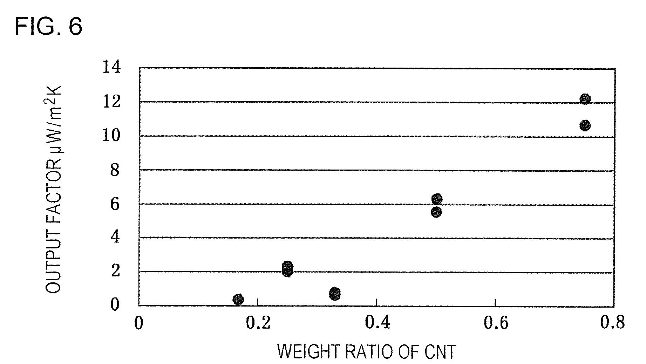

FIG. 6 shows a relationship of the output factor when the organic material was fixed to polystyrene, and the concentration of the CNT was changed. In addition, when α was set as the Seebeck coefficient, and p was set as the electrical resistivity, the output factor was calculated by an expression of α²/ρ.

The output factor was improved concurrently with an increase in the concentration of the CNT. On the other hand, when the CNT was set to 90 % by weight or more, the structural flexibility greatly decreased. Accordingly, when bending was performed, collapse easily occurred.

As described above, the CNT carries a function of voltage generation and electrical conduction of the CNT-dispersed organic material. Accordingly, when an organic material having flexibility other than the organic material used in this experiment is used, the same flexible thermoelectric conversion material is obtained. Here, as properties that are necessary for the organic material, three properties including low thermal conductivity, high heat resistant temperature, and structural flexibility are important so as to easily apply a temperature difference to an element. An organic material having the three properties is suitable for application of the CNT-dispersed organic material to thermoelectric conversion. As the organic material, any one of polyamide imide, polyimide, polyvinylidene fluoride, polyphenylene oxide, a phenol resin, and polyether terephthalate, or an organic material containing any one of these is effective.

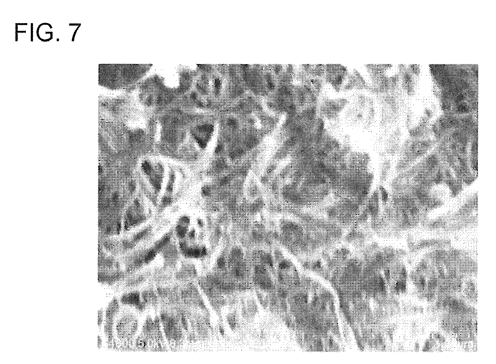

FIG. 7 shows an electron microscopic observation image of a surface of a material in which polystyrene was used as the organic material, and 50 % by mass of CNT was dispersed. Innumerable voids were observed in the material, and thus it was clear that the CNT-dispersed organic material was a porous material. As a result, it was considered that the voids decreased the thermal conduction of the thermoelectric conversion material of the present invention. Indeed, examination of the thermal conductivity of the obtained material by a laser flash method shows a value as low as 0.5 W/mK in a case of 50 % by mass of CNT, and a value as low as 0.63 W/mK in a case of 75 % by mass of CNT.

### (Example 3: Preparation of Thermoelectric Conversion Element by Stencil Printing)

A thermoelectric conversion element was prepared on a polyethylene naphthalate film substrate by a stencil printing method using the above-described CNT-dispersed organic material solution as ink. A preparation sequence is described below.

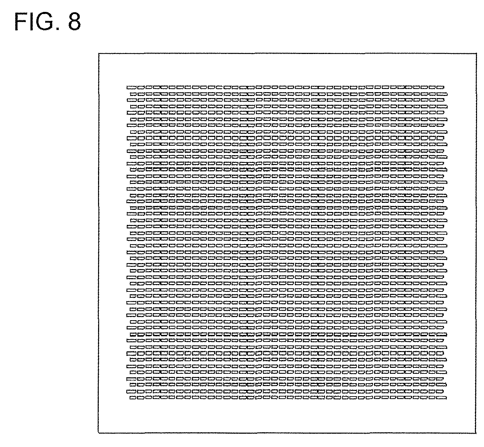

As a lower electrode, a laminated electrode of chromium (50 nm) and gold (200 nm) was formed on a film substrate of 12 cm × 12 cm in a pattern shape shown in FIG. 8 using a vacuum deposition method. Note that the laminated electrode of chromium and gold was used in this example, but other metal material may be used.

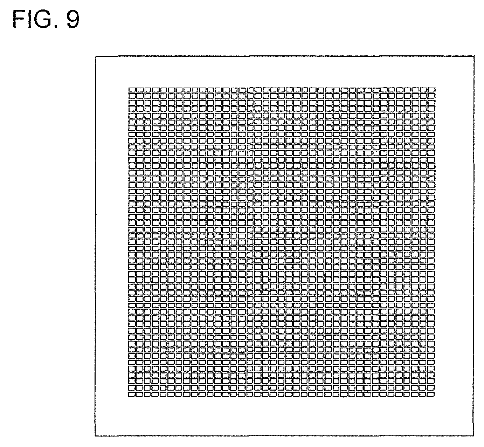

A printing plate (stencil plate) having a pattern shown in FIG. 9 was placed on the film substrate on which the lower electrode was formed, and the above-described ink was applied from an upper side of the plate and was dried to form a pattern of the CNT-dispersed organic material.

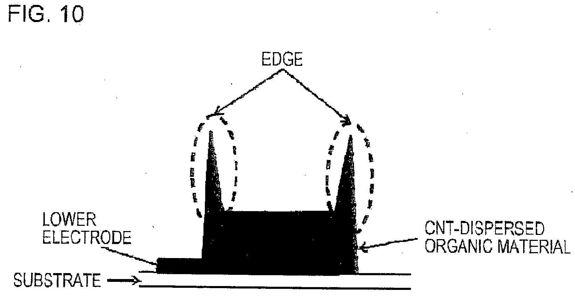

With regard to the shape of the CNT-dispersed organic material that was prepared as described above, a shape, in which an edge rose sharply as shown in FIG. 10 and which was considered to be caused due to a drying process of the solvent, was observed. If an upper electrode was formed on the CNT-dispersed organic material by a vacuum deposition method, for example, disconnection at the edge portion was frequently observed. Accordingly, it is necessary to form the upper electrode by a method with which the disconnection does not occur even when the edge is generated.

In response, in this example, the upper electrode was formed using a silver paste (Dotite D-550 manufactured by FUJIKURAKASEI CO., LTD) in a shape climbing over the edge portion. Note that as the material of the upper electrode, a metal paste of copper, nickel, or the like may be used in addition to silver. In this manner, an element having a structure in which the upper electrode was connected to a lower electrode of an adjacent element was prepared.

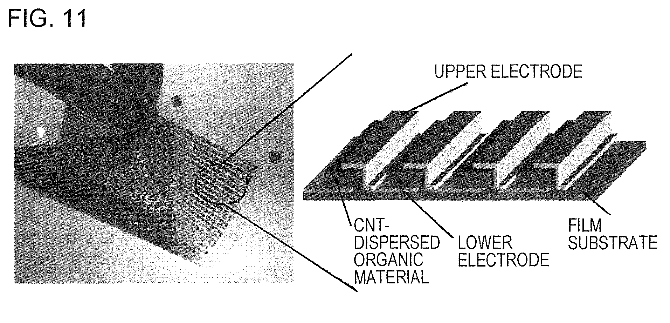

FIG. 11 shows a schematic diagram illustrating the entire image of the flexible thermoelectric conversion element prepared in this example, and a partially enlarged portion thereof.

The prepared flexible thermoelectric conversion element had a structure in which elements having a width of 0.5 mm × a length of 0. 8 mm × a thickness of 0. 3 mm were serially connected in 1,000 stages. In the thermoelectric conversion element prepared as described above, it was confirmed that mechanical damages were not shown even when the element was bent in a radius of curvature of approximately 5 mm, and adaptability with respect to installation in a curved or spherical shape was high. In addition, even in a temperature difference of approximately room temperature (10 °C) and a body temperature (36 °C), generation of a voltage of 0.1 V was confirmed, and a satisfactory temperature difference power generation operation was shown.

## Claims

1. A thermoelectric conversion material comprising:
(i) an organic polymeric material that
- is soluble in an organic solvent,
- has electrical insulating or semiconductive properties, and
- has flexibility,
in which a fine particle of a carbon nanotube is dispersed, the mass ratio of the carbon nanotube to the organic material being 50-90 % by mass; and
(ii) a void.

2. The thermoelectric conversion material of claim 1,
wherein the organic material contains a foaming agent, and the foaming agent is foamed to reduce thermal conductivity.

3. A thermoelectric conversion element, comprising a layer of the thermoelectric conversion material of claim 1 or 2 over a film substrate.

4. A thermoelectric conversion element, comprising the thermoelectric conversion material of claim 1 or 2 as a thermoelectric conversion layer,
wherein a plurality of thermoelectric conversion elements is disposed over a film substrate, the plurality of thermoelectric conversion elements including an electrode sandwiching an upper portion and a lower portion of the thermoelectric conversion layer,
and the upper electrode of one thermoelectric conversion element is brought into contact with the lower electrode of another adjacent thermoelectric conversion element to connect the plurality of thermoelectric conversion elements in series.

5. The thermoelectric conversion element of claim 3 or 4, further comprising an electrode formed by applying a conductive paste containing metal particles on an upper portion of the thermoelectric conversion layer, and drying the conductive paste.

6. The thermoelectric conversion element of any of claims 3-5, wherein the substrate is supported by metal foil.

7. A method of manufacturing the thermoelectric conversion element of any of claims 3-6, comprising:
applying a dispersed solution in which a fine particle of a carbon nanotube and an organic material are dispersed in a solvent such that a mass ratio of the carbon nanotube to the organic material becomes 50-90 % by mass on a film substrate or a film substrate having an electrode formed thereon, and
drying the application solution to form a thermoelectric conversion layer.

8. A waste heat utilization device, wherein the thermoelectric conversion element of any of claims 3-6 is installed to be attached to a heat release portion of a facility such as an apparatus and a pipe.

9. A waste heat utilization device, wherein an electronic apparatus having flexibility is set as a substrate, and a layer of the thermoelectric conversion material of claim 1 or 2 is formed over the substrate.

## Patentansprüche

1. Thermoelektrisches Umwandlungsmaterial umfassend:
(i) ein organisches polymeres Material, das
- in einem organischen Lösungsmittel löslich ist,
- elektrisch isolierende oder halbleitende Eigenschaften aufweist, und
- Flexibilität aufweist,
in dem ein Feinpartikel eines Kohlenstoff-Nanoröhrchens dispergiert ist, wobei das Masseverhältnis von Kohlenstoff-Nanoröhrchen zu organischem Material 50 bis 90 Masse-% beträgt; und
(ii) einen Hohlraum.

2. Thermoelektrisches Umwandlungsmaterial gemäss Anspruch 1, wobei das organische Material ein Schäumungsmittel enthält, und das Schäumungsmittel geschäumt ist, um die Wärmeleitfähigkeit zu reduzieren.

3. Thermoelektrisches Umwandlungselement, umfassend eine Schicht des thermoelektrischen Umwandlungsmaterials gemäss Anspruch 1 oder 2 über einem Foliensubstrat.

4. Thermoelektrisches Umwandlungselement, umfassend ein thermoelektrisches Umwandlungsmaterial gemäss Anspruch 1 oder 2 als thermoelektrische Umwandlungsschicht,
wobei eine Vielzahl an thermoelektrischen Umwandlungselementen über einem Foliensubstrat angeordnet ist, wobei die Vielzahl an thermoelektrischen Umwandlungselementen eine Elektrode einschliesst, die einen oberen Bereich und einen unteren Bereich der thermoelektrischen Umwandlungsschicht sandwichartig umschliesst,
und die obere Elektrode eines thermoelektrischen Umwandlungselements mit der unteren Elektrode eines anderen benachbarten thermoelektrischen Umwandlungselements in Kontakt gebracht wird, um die Vielzahl an thermoelektrischen Umwandlungselementen in Reihe zu schalten.

5. Thermoelektrisches Umwandlungselement gemäss Anspruch 3 oder 4, das ferner eine Elektrode umfasst, die durch Aufbringen einer leitfähigen Paste, die Metallpartikel enthält, auf einen oberen Bereich der thermoelektrischen Umwandlungsschicht, und Trocknen der leitfähigen Paste gebildet wird.

6. Thermoelektrisches Umwandlungselement gemäss einem der Ansprüche 3 bis 5, wobei das Substrat von einer Metallfolie getragen wird.

7. Verfahren zur Herstellung des thermoelektrischen Umwandlungselements gemäss einem der Ansprüche 3 bis 6, umfassend:
Aufbringen einer dispergierten Lösung, in der ein Feinpartikel eines Kohlenstoff-Nanoröhrchens und ein organisches Material in einem Lösungsmittel so dispergiert sind, dass das Masseverhältnis von Kohlenstoff-Nanoröhrchen zu organischem Material 50 bis 90 Masse-% beträgt, auf ein Foliensubstrat oder ein Foliensubstrat, das eine darauf gebildete Elektrode aufweist, und
Trocknen der Anwendungslösung, um eine thermoelektrische Umwandlungsschicht zu bilden.

8. Abwärmenutzungsvorrichtung, worin das thermoelektrische Umwandlungselement gemäss einem der Ansprüche 3 bis 6 so installiert ist, dass es an einen Wärmefreigabeteil einer Anlage, wie beispielsweise eine Vorrichtung und ein Rohr, angebracht ist.

9. Abwärmenutzungsvorrichtung, wobei eine elektronische Vorrichtung, die Flexibilität aufweist, als Substrat eingesetzt wird, und eine Schicht des thermoelektrischen Umwandlungsmaterials gemäss Anspruch 1 oder 2 über dem Substrat gebildet ist.

## Revendications

1. Matériau de conversion thermoélectrique comprenant :
(i) un matériau polymère organique qui
- est soluble dans un solvant organique,
- présente des propriétés électriques isolantes ou semi-conductrices et
- possède une certaine flexibilité,
dans lequel une particule fine d'un nanotube de carbone est dispersée, le rapport massique du nanotube de carbone au matériau organique étant de 50 à 90 % en masse ; et
(ii) un vide.

2. Matériau de conversion thermoélectrique selon la revendication 1, dans lequel le matériau organique contient un agent moussant et l'agent moussant forme de la mousse pour réduire la conductibilité thermique.

3. Elément de conversion thermoélectrique comprenant une couche du matériau de conversion thermoélectrique selon la revendication 1 ou la revendication 2 sur un substrat de film.

4. Elément de conversion thermoélectrique comprenant le matériau de conversion thermoélectrique selon la revendication 1 ou la revendication 2 comme couche de conversion thermoélectrique,
dans lequel une pluralité d'éléments de conversion thermoélectrique sont agencés sur un substrat de film, la pluralité d'éléments de conversion thermoélectrique comportant une électrode prenant en sandwich une partie supérieure et une partie inférieure de la couche de conversion thermoélectrique,
et l'électrode supérieure d'un élément de conversion thermoélectrique est amenée en contact avec l'électrode inférieure d'un autre élément de conversion thermoélectrique adjacent pour connecter la pluralité d'éléments de conversion thermoélectrique en série.

5. Elément de conversion thermoélectrique selon la revendication 3 ou la revendication 4, comprenant en outre une électrode formée par application d'une pâte conductrice contenant des particules métalliques sur une partie supérieure de la couche de conversion thermoélectrique et séchage de la pâte conductrice.

6. Elément de conversion thermoélectrique selon l'une quelconque des revendications 3 à 5, dans lequel le substrat est supporté par une feuille métallique.

7. Procédé de fabrication de l'élément de conversion thermoélectrique selon l'une quelconque des revendications 3 à 6, comprenant :
l'application d'une solution dispersée, dans laquelle une particule fine d'un nanotube de carbone et un matériau organique sont dispersés dans un solvant de sorte que le rapport massique du nanotube de carbone au matériau organique devienne de 50 à 90 % en masse sur un substrat de film ou un substrat de film sur lequel une électrode des formée et
le séchage de la solution d'application pour former une couche de conversion thermoélectrique.

8. Dispositif d'utilisation de chaleur perdue, dans lequel l'élément de conversion thermoélectrique selon l'une quelconque des revendications 3 à 6 est installé pour être attaché à une partie de libération de chaleur d'une installation telle qu'un appareil et un tuyau.

9. Dispositif d'utilisation de chaleur perdue, dans lequel un appareil électronique présentant une certaine flexibilité est défini comme substrat et une couche du matériau de conversion thermoélectrique selon la revendication 1 ou la revendication 2 est formée sur le substrat.
